# EUROPEAN PATENT SPECIFICATION

(11) **EP 0 523 263 B1**
(45) Date of publication and mention of the grant of the patent: **08.01.1997**
(21) Application number: 91111812.3
(22) Date of filing: 16.07.1991
(51) Int. Cl.: G01R 23/167, G01R 23/165, G01R 23/07, G01R 19/00

(54) **A method for determining the frequency of a dominant signal in an input signal**
Methode zur Bestimmung der Frequenz eines dominanten Signals in einem Eingangssignal
Procédé pour déterminer la fréquence d'un signal dominant dans le signal d'entrée

(43) Date of publication of application: 20.01.1993
(73) Proprietor: WAVETEK GMBH, 85737 Ismaning (DE)
(72) Inventor: Csanadi, Gabor, W-8000 München 40 (DE)
(74) Representative: Sparing Röhl Henseler Patentanwälte

(56) References cited:
- DE-A- 3 817 499
- FR-A- 2 478 355
- GB-A- 1 434 028
- US-A- 4 326 261
- ELECTRONICS LETTERS vol. 16, no. 17, August 1980, HITCHIN HERTS pages 672 - 673; 'RECURSIVE FILTER WITH UNIFORM POWER DISTRIBUTION'

## Description

The present invention relates to a method for determining the frequency of a dominant signal in a given spectrum of input signals. The dominant signal or component is that which has the greatest amplitude but which is only one component in a given spectrum including numerous noise and other disturbing components.

A typical application of the method is the determination of the frequency and, sometimes, also the amplitude of sub audio signals in radio communication. Such sub audio signals are transmitted in a spectrum of e.g. 60 to 250 cps together with speech signals, and the received signal usually includes superposed broad band noise. Therefore it is difficult to directly measure the frequency of the dominant sub audio frequency with the desired accuracy.

An obvious solution is the fast Fourier transformation. However, the number of samples must be high in order to obtain a sufficient resolution, and if the period of the signal to be measured is in the order of magnitude of the entire length of the signal portion to be transformed, a phenomenon known under the term "leakage" will occur with resulting inacceptable errors in the measured frequency and amplitude. It is known to overcome these problems by the so-called windowing technique or by increasing the number of samples; thus, the procedure may become very time consuming.

Another obvious approach is the use of a low pass, a high pass, or a band pass filter which only permits passage of a frequency range wherein the dominant signal is expected. However, such a filter must have outstanding quality seen the fact that the frequency of the dominant component and of any disturbing signal may be very close and the amplitude of such disturbing signal may exceed that of the searched signal.

It is the object of the present invention to provide a method and an apparatus for determining the frequency of a dominant signal in an input signal of a given spectrum wherein the measurement may be quickly executed and wherein the components used to make the measurements can be simple and inexpensive.

A method including the steps:
(a) feeding the input signal via a tunable band pass filter to a frequency meter,
(b) tuning the filter towards resonance with the measured frequency, and
(c) repeating step (a) with the input signal is known from document GB-A-1 434 028.

The present invention distinguishes over the cited document in that in step (c), the input signal is replaced with the filtered signal.

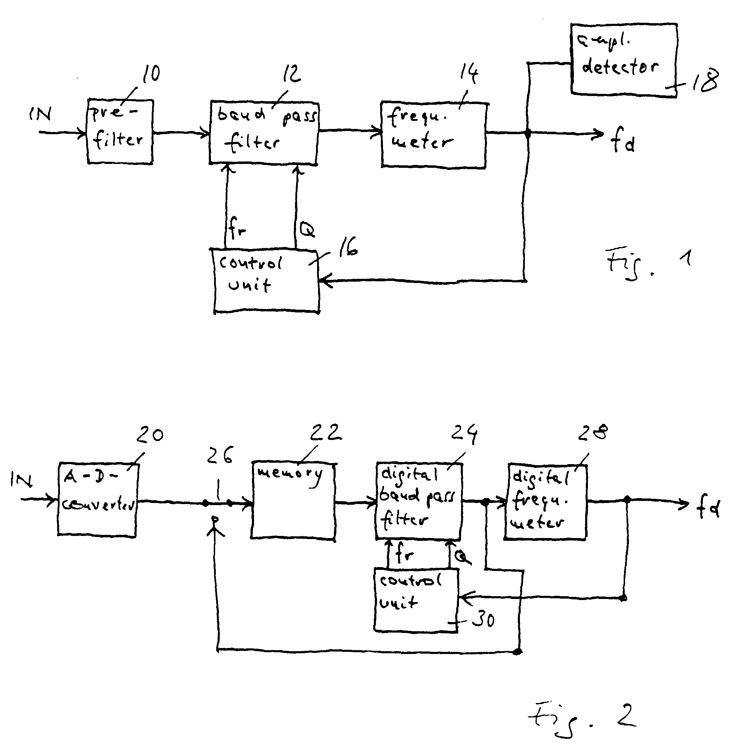

Embodiments of an apparatus to implement the method of the invention are illustrated in Fig. 1 and Fig. 2, respectively.

In Fig. 1, the input signal IN, for example a received radio transmission signal, is fed to a pre-filter 10 which need not be of high quality and simply serves the purpose to attenuate components of the spectrum range within which the searched dominant signal cannot be. For the case of sub audio signals mentioned above, filter 10 would attenuate all components having frequencies beyond 250 cps. The remaining spectrum is fed to band pass filter 12 which is a programmable filter, i.e. its resonance frequency and quality factor Q are adjustable. At first, the resonance frequency is set to be about at the center of the spectrum fed to band pass filter 12, and the quality factor is set to be rather poor so that the dominant frequency will pass the filter substantially unattenuated. The output of filter 12 is connected to the input of frequency meter 14, and at the output of the latter a frequency will be indicated which is close to the dominant frequency. This output frequency f_{d} is fed to a control unit 16 which, in response to this "coarse" frequency, sets band pass filter 12 to be in resonance therewith. Simultaneously, control unit 16 is activated to increase the quality factor Q of band pass filter 12 by a given increment. Accordingly, the output f_{d} of frequency meter 14 will be far more accurate with the band pass filter having narrowed pass band. If desired, the procedure may be repeated once more or even several times until the difference between the measured f_{d}'s of two successive measurements has decreased to an acceptable minimum. Often it is not the frequency f_{d} which is to be read but the amplitude of the signal at this frequency so that an amplitude detector 18 is provided. The accuracy of its reading depends, of course, upon the accuracy with which the band pass filter was adjusted. It is to be noted that the means to replace the input signal by the filtered signal are not illustrated in Fig. 1 but may simply be adopted from what is shown in Fig. 2.

Fig. 2 shows a digital implementation of the circuit. The input signal is converted, by means of A/D converter 20, into a digital signal which, at first, is memorized in a memory 22. The contents of the memory are retrieved and processed by means of digital band pass filter 24, and switch 26 is actuated so that the memory write inputs are connected to the output of digital bandpass filter 24 (the bus connections are shown as single lines for purpose of simplification). The data processed by filter 24 are fed to digital frequency meter 28 which may be a simple counter, and the output of the latter is used to set filter 24 via control unit 30. Digital signal processing involves operations which are described, for example, in "Theory and Application of Digital Signal Processing" by Rabiner and Gold, Prentice-Hall Inc., Englewood Cliff, New Jersey.

It is to be noted that the pre-filtering step and the amplitude measurement step of Fig. 1 may be provided in the embodiment of Fig. 2, too. Similarly, the memorizing technique of Fig. 2 could be similarly provided in the embodiment of Fig. 1.

## Claims

1. A method for determining the frequency of a dominant signal in an input signal (IN) of a given spectrum, comprising the steps of:
(a) feeding said input signal (IN) via a band pass filter (12, 24) to a frequency meter (14, 28);
(b) tuning said band pass filter (12, 24) such that it is in closer resonance with the measured frequency, said frequency being the dominant signal frequency;
characterized by
(c) feeding the filtered signal to the band pass filter (24) instead of said input signal (IN) and
(d) repeating steps (b) and (c).

2. The method of claim 1 wherein after step (c), steps (b) and (c) are executed for at least a second times.

3. The method of claim 1 or 2 wherein prior to step (a) said input signal is pre-filtered (10) so as to attenuate signal components outside said given spectrum.

4. The method of claim 1 or 2 or 3 wherein prior to each step (c) the Q-factor of said band pass filter (12, 24) is increased.

5. The method of claim 1 or 2, 3, 4 including the step of measuring (18) the amplitude of said dominant signal after step (c).

6. The method of claim 1 wherein said input signal (IN) is subjected to an analog-to-digital conversion (20), digital data so obtained is memorized (22), and steps (a) through (c) are digitally executed on said memorized data.

7. An apparatus for determining the frequency of a dominant signal in an input signal (IN) of a given spectrum, comprising
(a) a band pass filter (24) having an input fed with said input signal (IN) and having an output,
(b) a frequency meter (28) having an input connected to said band pass filter output and having an output,
characterized by
(c) a control unit (30) connected to a frequency and/or quality factor (Q) control input of said band pass filter (24) and having an input connected to the output of said frequency meter (28) so as to bring said band pass filter (24) in closer resonance with the measured frequency, said frequency being the dominant signal frequency,
(d) a switch means (26) for feeding said band pass filter (24) either with said input signal (IN) or said filtered signal.

8. The apparatus of claim 7 wherein said control unit (16, 30) is adapted to increase the Q-factor of said band pass filter (12, 24) in response to an input from said frequency meter (14, 28).

9. The apparatus of claim 7 or 8 further comprising a pre-filter (10) adapted to attenuate components of an input signal (IN) outside said given spectrum.

10. The apparatus of claims 7, 8 or 9 including an analog-to-digital converter (20) and a memory means (22) for memorizing signals to be filtered by said band pass filter (24).

11. The apparatus of claim 10 including means for overwriting a memorized signal by a signal filtered by said band pass filter.

## Patentansprüche

1. Ein Verfahren zum Bestimmen der Frequenz eines dominanten Signals in einem Eingangssignal (IN) eines gegebenen Spektrums, umfassend die Schritte:
(a) Zuführen des Eingangssignals (IN) über ein Bandpassfilter (12, 24) zu einem Frequenzmesser (14, 28);
(b) Abstimmen des Bandpassfilters (12, 24) derart, daß es in enger Resonanz mit der gemessenen Frequenz ist, welche Frequenz die dominante Signalfrequenz ist;
gekennzeichnet durch
(c) Zuführen des gefilterten Signals zu dem Bandpassfilter (24) anstelle des Eingangssignals (IN) und
(d) Wiederholen der Schritte (b) und (c).

2. Das Verfahren nach Anspruch 1, bei dem nach Schritt (c) die Schritte (b) und (c) mindestens ein zweites Mal ausgeführt werden.

3. Das Verfahren nach Anspruch 1 oder 2, bei dem vor dem Schritt (a) das Eingangssignal vorgefiltert (10) wird, um so Signalkomponenten außerhalb des gegebenen Spektrums zu dämpfen.

4. Das Verfahren nach Anspruch 1 oder 2 oder 3, bei dem vor dem Schritt (c) der Q-Faktor des Bandpassfilters (12, 24) erhöht wird.

5. Das Verfahren nach Anspruch 1 oder 2, 3, 4 einschließlich des Schrittes der Messung (18) der Amplitude des dominanten Signals nach dem Schritt (c).

6. Das Verfahren nach Anspruch 1, bei dem das Eingangssignal (IN) einer Analog-Digital-Umsetzung (20) unterworfen wird, die so gewonnenen Digitaldaten abgespeichert (22) werden und die Schritte (a) bis (c) digital an den abgespeicherten Daten ausgeführt werden.

7. Eine Vorrichtung für das Bestimmen der Frequenz eines dominanten Signals in einem Eingangssignal (IN) eines gegebenen Spektrums, umfassend
(a) ein Bandpassfilter (24) mit einem Eingang, der mit dem Eingangssignal (IN) gespeist wird, und mit einem Ausgang,
(b) einen Frequenzmesser (28) mit einem Eingang, der mit dem Bandpassfilterausgang verbunden ist, und mit einem Ausgang,
gekennzeichnet durch
(c) eine Steuereinheit (30), verbunden mit einem Frequenz- und/oder Gütefaktor(Q)-Steuereingang des Bandpassfilters (24), und mit einem Eingang, angeschlossen an den Ausgang des Frequenzmessers (28), um so das Bandpassfilter (24) in dichtere Resonanz mit der gemessenen Frequenz zu bringen, welche Frequenz die dominante Signalfrequenz ist,
(d) ein Schaltermittel (26) für das Speisen des Bandpassfilters (24) entweder mit dem Eingangssignal (IN) oder mit dem gefilterten Signal.

8. Die Vorrichtung nach Anspruch 7, bei der die Steuereinheit (16, 30) für das Erhöhen des Q-Faktors des Bandpassfilters (12, 24) in Reaktion auf einen Eingang von dem Frequenzmesser (14, 28) ausgebildet ist.

9. Die Vorrichtung nach Anspruch 7 oder 8, ferner umfassend ein Vorfilter (10), ausgebildet zum Dämpfen von Komponenten eines Eingangssignals (IN), die außerhalb des gegebenen Spektrums liegen.

10. Die Vorrichtung nach Anspruch 7, 8 oder 9 einschließlich eines Analog-Digital-Umsetzers (20) und eines Speichermittels (22) für das Abspeichern von mittels des Bandpassfilters (24) zu filternder Signale.

11. Die Vorrichtung nach Anspruch 10 einschließlich Mitteln für das Überschreiben eines abgespeicherten Signals durch ein von dem Bandpassfilter gefiltertes Signal.

## Revendications

1. Procédé pour déterminer la fréquence d'un signal dominant dans un signal d'entrée (IN) d'un spectre donné, comprenant les étapes consistant à :
(a) fournir ledit signal d'entrée (IN) via un filtre passe-bande (12, 24) à un fréquencemètre (14, 28);
(b) régler ledit filtre passe-bande (12, 24) de telle sorte qu'il est en résonance plus proche avec la fréquence mesurée, ladite fréquence étant la fréquence du signal dominant;
caractérisé par
(c) la fourniture du signal filtré au filtre passe-bande (24) à la place dudit signal d'entrée (IN) et
(d) la répétition des étapes (b) et (c).

2. Procédé selon la revendication 1 dans lequel après l'étape (c), les étapes (b) et (c) sont exécutées au moins une deuxième fois.

3. Procédé selon la revendication 1 ou 2 dans lequel avant l'étape (a) ledit signal d'entrée est préfiltré (10) de façon à atténuer les composantes de signal se trouvant à l'extérieur dudit spectre donné.

4. Procédé selon la revendication 1, 2 ou 3 dans lequel le facteur Q dudit filtre passe-bande (12, 24) est augmenté avant chaque étape (c).

5. Procédé selon la revendication 1 ou 2, 3, 4 comprenant l'étape de mesure (18) de l'amplitude dudit signal dominant après l'étape (c).

6. Procédé selon la revendication 1 dans lequel ledit signal d'entrée (IN) est soumis à une conversion analogique à numérique (20), les données numériques ainsi obtenues sont mémorisées (22) et les étapes (a) à (c) sont réalisées numériquement sur lesdits données mémorisées.

7. Appareil pour déterminer la fréquence d'un signal dominant dans un signal d'entrée (IN) d'un spectre donné, comprenant
(a) un filtre passe-bande (24) ayant une entrée alimentée avec ledit signal d'entrée (IN) et ayant une sortie,
(b) un fréquencemètre (28) ayant une entrée connectée à ladite sortie du filtre passe-bande et ayant une sortie,
caractérisée par
(c) une unité de commande (30) connectée à une entrée de commande de fréquence et/ou de facteur de qualité (Q) dudit filtre passe-bande (24) et ayant une entrée connectée à la sortie dudit fréquencemètre (28) de façon à amener ledit filtre passe-bande (24) en résonance plus proche avec la fréquence mesurée, ladite fréquence étant la fréquence du signal dominant,
(d) des moyens de commutation (26) pour fournir audit filtre passe-bande (24) soit ledit signal d'entrée (IN) soit ledit signal filtré.

8. Appareil selon la revendication 7 dans lequel ladite unité de commande (16, 30) est apte à augmenter le facteur Q dudit filtre passe-bande (12, 24) en réponse à une entrée provenant dudit fréquencemètre (14, 28).

9. Appareil selon la revendication 7 ou 8 comprenant un préfiltre (10) apte à atténuer les composantes d'un signal d'entrée (IN) en dehors dudit spectre donné.

10. Appareil selon la revendications 7, 8 ou 9 comprenant un convertisseur analogique à numérique (20) et des moyens à mémoire (22) pour mémoriser des signaux devant être filtrés par ledit filtre passe-bande (24).

11. Appareil selon la revendication 10 comprenant des moyens pour écrire par dessus un signal mémorisé un signal filtré par ledit filtre passe-bande.
